# EUROPÄISCHE PATENTSCHRIFT

(11) **EP 2 347 449 B1**
(45) Veröffentlichungstag und Bekanntmachung des Hinweises auf die Patenterteilung: **25.03.2015**
(21) Anmeldenummer: 09764442.1
(22) Anmeldetag: 04.11.2009
(51) Int. Cl.: H01L 51/44, H01L 51/50, H01L 31/0392, D03D 1/00, H01L 51/42

(54) **SUBSTRAT FÜR EINE OPTOELEKTRONISCHE VORRICHTUNG**
SUBSTRATE FOR OPTOELECTRONIC DEVICE
SUBSTRAT POUR DES DISPOSITIFS OPTOELECTRONIQUE

(30) Priorität: 05.11.2008 DE 102008055969
(43) Veröffentlichungstag der Anmeldung: 27.07.2011
(73) Patentinhaber: SEFAR AG, 9425 Thal (CH)
(72) Erfinder: CHABRECEK, Peter, CH-9306 Freidorf (CH); MEIER, Hanspeter, CH-9112 Schachen (CH); NÜESCH, Frank, CH-8602 Wangen (CH); ROSENFELDER, Matthias, CH-9036 Grub SG (CH); ARAUJO DE CASTRO, Fernando, TW16 7QN Sunbury-on-Thames Surrey (GB)
(74) Vertreter: Behrmann, Niels
(86) Internationale Anmeldenummer: PCT/EP2009/007894
(87) Internationale Veröffentlichungsnummer: WO 2010/051976

(56) Entgegenhaltungen:
- WO-A1-2005/067042
- WO-A2-03/065471
- WO-A2-2007/138348
- GB-A- 2 424 121
- US-A- 4 414 264
- LIU JIWEN ET AL: "Fiber-based architectures for organic photovoltaics" APPLIED PHYSICS LETTERS, AIP, AMERICAN INSTITUTE OF PHYSICS, MELVILLE, NY, US, Bd. 90, Nr. 6, 5. Februar 2007 (2007-02-05), Seiten 63501-063501, XP012095981 ISSN: 0003-6951

## Beschreibung

Die vorliegende Erfindung betrifft ein Substrat für eine optoelektronische Vorrichtung nach dem Oberbegriff des Patentanspruchs 1, wie aus der GB 2 424 121 A bekannt.

Aus dem Stand der Technik sind zahlreiche Wege bekannt, um eine Trägerschicht (Substrat) für eine optoelektronische Vorrichtung, etwa eine Solarzelle, zu realisieren. Dabei ist es zunächst bekannt und weit verbreitet, bei Solarzellen der so genannten ersten Generation Siliziumsubstrate vorzusehen,

Gerade in jüngster Zeit zeigen diese Produkte steigende Effizienz, sowohl im Hinblick auf den elektrischen Wirkungsgrad, als auch die (Massen-) Fertigbarkeit, gleichzeitig sind nach wie vor die prinzipbedingten Kosten, eingeschlossen die Materialkosten des Siliziums, zu hoch, um derartigen Solarzellen eine weitere Verbreitung zu ermöglichen.

So genannte Solarzellen der zweiten Generation benötigen kein Silizium mehr. Hier wird mit Hilfe von verschiedenen Abscheidungstechnologien, etwa Plasma-Sputtern, oder CVD, auf ein transparentes Substrat, typischerweise eine Glasplatte oder ein flexibles Polyamid, ein Kostenvorteil durch die preisgünstigeren Substrate erreicht, nach wie vor scheinen jedoch auch bei dieser zweiten Generation Substratkosten (und i.ü. auch deren Flexibilität im Einsatz) verbesserungsbedürftig.

Es bestehen daher Bestrebungen, mit so genannten Photovoltaik-Technologien der dritten Generation die Substratkosten (als signifikanten Kostentreiber) weiter abzusenken, wobei nach wie vor vertretbare Wirkungsgrade (typischerweise ca. 10 %) realisiert werden sollen. Schlüsseltechnologien zum Erreichen dieser Ziele setzen einerseits preisgünstige Substrate (etwa Folien oder Gewebe) für die aktiven Komponenten voraus, andererseits Herstellungsprozesse bei Niedrigtemperatur sowie Umgebungsdruck (wie etwa Digital- oder Siebdruck) sowie einen hohen Durchsatz in der Herstellung. Es wird erwartet, dass insbesondere organische Solarzellen, Tandemzellen oder so genannte DSC-Solarzellen (dye-sensitized nano-structured solar cells) das Potenzial bieten, die Ziele zu erreichen,

Während zudem mit den vorbeschriebenen siliziumbasierten Solarzellen der ersten Generation halbleiterbasierte Substrate nach wie vor dominierend sind, erweisen sich zunehmend nicht-halbleiterbasierte Substrate als leistungsfähige und technologische Alternativen: So erweist sich etwa die Fähigkeit mancher nicht-Si photovoltaischer Materialien, bei niedrigen Licht-Einfallswinkeln oder niedriger Lichtintensität oder sogar bei polarisierten Lichtquellen Strom zu erzeugen (es wird auch ein breiteres Lichtspektrum ausgenutzt), als vorteilhaft gegenüber Silizium; gleichermaßen werden die Vorteile flexibler Substrate (also z.B. auf Folien- oder Gewebebasis) wahrgenommen, wenn Solarzellen gerollt oder gefaltet werden müssen, oder andere freie Formbarkeiten für verschiedene Anwendungsumgebungen gefordert sind. Gleichzeitig fehlt es jedoch nach wie vor an einem preisgünstigen, leistungsfähigen und insbesondere auch einfach und zuverlässig in großer Serie herzustellenden Substratmaterial für optoelektronische Vorrichtungen, wie etwa Solarzellen,

Zum weiteren Stand der Technik wird auf die US 4 414 264 A verwiesen.

Aufgabe der vorliegenden Erfindung ist es daher, ein gattungsgemäßes Substrat für eine optoelektronische Vorrichtung, insbesondere eine Photovoltaik- bzw. Solarzelle (oder OLED) zu schaffen, welche bei verbesserten optischen Eigenschaften, insbesondere Transmissionseigenschaften für zusammenwirkende aktive Schichten, eine vereinfachte, insbesondere großserientaugliche, Fertigbarkeit bei niedrigen Material- und Herstellungskosten und hoher Reproduzierbarkeit ermöglicht.

Die Aufgabe wird durch das Substrat mit den Merkmalen des Hauptanspruchs gelöst; vorteilhafte Weiterbildungen der Erfindung sind in den Unteransprüchen beschrieben. Erfindungsgemäß wird zusätzlich Schutz beansprucht für jegliche Kombination aus mindestens zwei Verfahrensmerkmalen, welche aus den vorliegenden Anmeldungsunterlagen ersichtlich sind; diese werden als zur Erfindung gehörig beansprucht.

Erfindungsgemäß vorteilhaft werden zunächst die für die Herstellung des Gewebes eingesetzten Fasern (Fibern) so eingerichtet oder ausgewählt, dass sie bei einem Faserdurchmesser zwischen 20µm und 100 µm, insbesondere zwischen 30µm und 80µm, aufweisen - typischerweise weisen die Fasern für eine jeweilige Realisierungsform einen konstanten Durchmesser auf. Zusätzlich vorteilhaft im Rahmen der Erfindung ist das Gewebe so ausgestaltet, dass die zwischen den verwobenen Fasern gebildeten Maschenöffnungen eine offene Fläche zwischen ca. 70% und ca. 85% realisieren; dies bedeutet, dass verbleibende 15% bis 30%, bezogen auf eine Gesamtfläche, von den Fasern eingenommen werden.

Weiter erfindungsgemäß vorteilhaft ist das Gewebe zumindest einseitig mit einer transparenten Beschichtung in der Art einer (z.B. teilweisen) Füllung versehen, welche durch ein elektrisch nicht-leitendes Polymer realisiert ist.

Auf diese Weise lässt sich erfindungsgemäß vorteilhaft realisieren, dass das Substrat auf einer ersten Seite (unbeschichtete Oberflächenseite) elektrisch leitend ist, da hier elektrisch leitende Fasern und/oder eine elektrisch leitende Beschichtung des Gewebes von der transparenten Polymerbeschichtung unbeeinflusst ist, während anderenends (auf der zweiten beschichteten Oberflächenseite) das transparente Polymermaterial für eine elektrische Isolation sorgt.

Das Polymermaterial kann weiter mit ORMOCER oder SiOx oder einem anderen anorganischen Material versehen, insbesondere beschichtet werden.

Vorteilhaft ermöglicht das gegebenenfalls so beschichtete Polymermaterial bzw. die damit gebildete transparente, elektrisch nicht-leitende Beschichtung eine Feuchtigkeits- und/oder UV-Beständigkeit (z.B. durch geeignete Beimischung eines UV-Absorbers) des Substrats (und mithin einer darauf aufgebauten optoelektronischen Vorrichtung), zusätzlich wirkt dieses Beschichtungsmaterial vorteilhaft und weiterbildungsgemäß als Oxidationssperre.

Mit einer Beschichtungsdicke, welche kleiner eingerichtet als eine Gewebedicke ist, typischerweise ca. 70% bis 85% der Gewebedicke beträgt und das Gewebe zumindest teilweise durchdringt, lässt sich so eine kompakte, optisch und physikalisch leistungsfähige, dabei gleichzeitig einfach und mit geringen Kosten herzustellende Substratanordnung realisieren.

Gemäß einer bevorzugten Weiterbildung der Erfindung ist für das Polymermaterial ein Material ausgewählt, welches ein Acrylharz, ein Silikonmaterial, ein Fluoropolymer sein kann, oder ein Polymer ausgewählt aus einer Gruppe bestehend aus PU, PEN, PI, PET, PA, EVA oder vergleichbaren Materialien, weiter bevorzugt thermisch- oder strahlenhärtend, wobei sich insbesondere ein UVstrahlenhärtender Lack als besonders bevorzugt herausgestellt hat.

Im Hinblick auf die erfindungsgemäßen Fasern (Fibern) ist es zunächst von der Erfindung umfasst, das Gewebe im Wesentlichen aus elektrisch nicht-leitenden Fasern herzustellen, welche dann zur Realisierung der Elektrodenwirkung mit einer elektrischen Leitfähigkeit versehen werden. Geeignete Fasern (Fibern) sind insbesondere semitransparente Monofilamente von PA, PP, PET, PEEK, PI, PPS oder dergleichen Chemiefasern.

Zum Herstellen der elektrischen Leitfähigkeit, wobei bevorzugt das für das erfindungsgemäße Substrat eingesetzte Gewebe einen Flächenwiderstand < 50Ω/sq, bevorzugt < 20Ω/sq, weiter bevorzugt kleiner 10Ω/sq, aufweist, ist es einerseits von der Erfindung umfasst, weiterbildungsgemäß Fasern im Gewebe vorzusehen, welche aus Metall bestehen (Metallfasern), oder als Fasern eine Metallisierung tragen. Geeignete Metalle zur Realisierung der Metallfasern sind etwa Ti, Ag, Al, Cu, Au, Pa, Pt, Ni, W, Mo, Nb, Ba, Sn, Zr od.dgl., wobei die Leitfähigkeit des Gewebes (bzw. der Flächenwiderstand) geeignet eingerichtet werden kann durch die Geometrie, mit welcher ein solcher metallischer bzw. metallisierter Faden zusammen mit nicht-leitenden Fäden verwoben wird: Im Rahmen geeigneter Ausführungsformen der Erfindung liegt es dabei, derartige leitende Fäden in Form einer Bindung 1:1, oder bevorzugt 1:2, 1:3 oder höher vorzusehen, ergänzend oder alternativ durch Auswahl der Richtung (Schuss, Kette), in welcher überhaupt eine metallische oder metallisierte Faser verwoben werden soll, die Leitfähigkeitseinstellung vorzunehmen (vorgesehen ist insbesondere auch Verweben in beide Richtungen Schuss, Kette).

Zum anderen ist es im Rahmen bevorzugter Realisierungsformen der Erfindung möglich und vorgesehen, die elektrische Leitfähigkeit bzw. den gewünschten niedrigohmigen Flächenwiderstand einzurichten durch eine Metallisierung des Gewebes, welches typischerweise dann selbst ausschließlich aus nicht-leitenden Polymerfasern besteht (wobei prinzipiell auch hier metallische Fasern eingewoben sein können). Eine derartige metallische Beschichtung des Gewebes kann geeignet durch Plasma-Sputtern erfolgen (z.B. mit Ag, Au, Ti, Mo, Cr, Cu, ITO, ZAO od.dgl.), alternativ durch Bedampfen (Al, Ag, Cu, usw.) oder aber durch nasschemische Verfahren wie Elektrolyse, etwa Abscheiden von Ag, Ni. Typischerweise bewirkt eine derartige Metallisierung des Gewebes eine besonders hohe Leitfähigkeit, welche sich in einem Flächenwiderstand < 10Ω/sq niederschlägt.

Wie bereits eingangs erläutert, besteht ein besonderer Vorteil der Erfindung in der hohen Lichtdurchlässigkeit bzw. Transmission des erfindungsgemäß realisierten Substrats. Diese lässt sich besonders günstig beeinflussen durch Einstellung der erfindungsgemäß eingerichteten Maschenöffnungen, wobei insbesondere bekannte Verfahren zur Herstellung von Präzisionsgeweben hier günstig angewendet werden können. Zur Realisierung der erfindungsgemäß vorgesehenen Maschenöffnungen bei der erfindungsgemäß offenen Fläche zwischen 70% und 85% hat es sich als besonders bevorzugt herausgestellt, Maschenweiten im Bereich zwischen 200µm und 300µm einzustellen bzw. die Fläche einer jeweiligen Maschenöffnung (bevorzugt konstant über die Fläche) auf einen Bereich zwischen ca. 80.000µm² und ca. 800.000 µm² einzurichten.

Erfindungsgemäß vorteilhaft ist zudem in der Regel die gesamte Transmission (in %) eines erfindungsgemäß hergestellten Substrats höher als die offene Fläche des Gewebes; zur so genannten direkten Transmission, nämlich des Lichtdurchtritts durch die Maschen sowie durch transparente Fibern, kommt hinzu eine diffusive Transmission, welche (etwa bei metallisch beschichteten Fasern) eine Reflexion an der Faser oder durch die Faser berücksichtigt, so dass im Ergebnis bei einem Bereich der erfindungsgemäß offenen Fläche zwischen 70% und 85% eine tatsächliche gesamte Transmission zwischen 75% und 95% erreichbar ist.

Die vorliegende Erfindung ermöglicht damit in potenziell einfacher, eleganter und preiswerter Weise die Herstellung von optoelektronischen Vorrichtungen für eine Vielzahl von Anwendungen: Während sich die Photovoltaik als Hauptverwendung für die vorliegende Erfindung erweisen dürfte, wobei insbesondere organische Solarzellen, Dünnschichtzellen, DSC-Zellen oder Tandemzellen in der erfindungsgemäßen Weise auf das Substrat aufgebracht werden können, ist es gleichwohl günstig und von der Erfindung umfasst, andere optoelektronische Vorrichtungen mit dem Substrat zu realisieren. Hierzu gehören organische LEDs, sonstige Display-Technologien, verschiedene passive elektronische Bauelemente oder aber großflächige Bauelemente, wie sie etwa für Architekturanwendungen od.dgl. eingesetzt werden.

Damit steht zu erwarten, dass die vorliegende Erfindung nicht nur zahlreiche Vorteile etwa gegenüber den bekannten TCO-Elektroden (Transparent Conductive Oxide, verwendet als transparente Elektrode) realisiert, wie etwa deutlich niedrigere Herstellungs- und Materialkosten, das fehlende Erfordernis einer speziellen Vakuumdruckanlage (TCO sind im Hochvakuum herzustellen), einfachere Technologie bei erhöhter Leitfähigkeit sowie verminderte Brüchigkeit und verbesserte Substrat-Adhäsion, auch dürfte überhaupt erst mittels des erfindungsgemäß vorgelegten Substrats die Möglichkeit eröffnet werden, großflächige, flexible Flächen als optoelektronische Vorrichtungen, insbesondere zu Zwecken der Photovoltaik (auch zur Herstellung von OLEDs), auszugestalten.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in
- Fig. 1: ein Substrat gemäß einer ersten bevorzugten Ausführungsform der Erfindung in der seitlichen Schnittansicht;
- Fig. 2: eine alternative Realisierungsform eines Substrats gemäß einer zweiten bevorzugten Ausführungsform;
- Fig. 3: eine schematische Schnittansicht einer organischen Solarzelle, realisiert mittels dem Substrat der ersten Ausführungsform gemäß Fig. 1; und
- Fig. 4:: eine weitere Ausführungsform der vorliegenden Erfindung, bei welcher die Beschichtung so in das Gewebe eingebracht ist, dass beidseits eine elektrisch leitende Schicht erzielt werden kann und so etwa eine Tandem-Solarzelle aufgebaut werden kann.

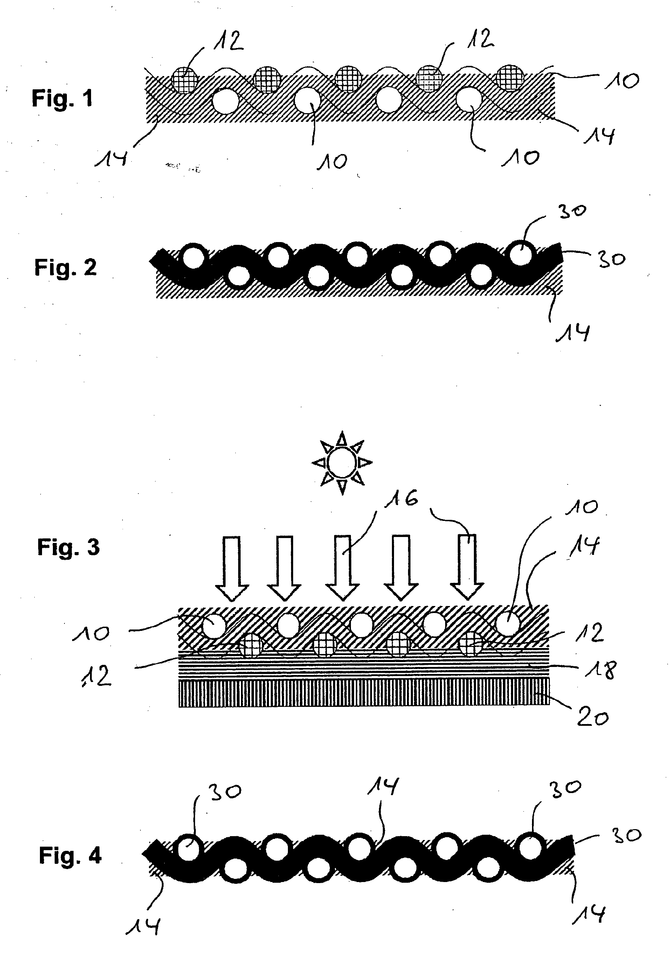

Die Fig. 1 zeigt in der seitlichen schematischen Schnittansicht ein Gewebe aus transparenten PA-Fasern 10, welche eine Dicke im Bereich zwischen 30µm und 35µm aufweisen. Jede zweite Faser im Schuss (alternativ auch in der Kette) ist ein Al-Metallfaden 12 einer vergleichbaren Fadendicke im Bereich zwischen ca. 30µm und 35µm.

Dieses Gewebe ist mit einer Beschichtung 14 aus einem transparenten Polymer (hier: UV-härtendes Acrylharz) so versehen, dass einends (in Fig. 1 unten) die Beschichtung 14, welche mit ca. 60µm 75% bis 85% der Schichtdicke des Gewebes 10, 12 erreicht, eine isolierende Schicht bildet, während im oberen Bereich mit den zumindest teilweise freiliegenden Metallfibern 12 die Anordnung elektrisch leitend ist und als Elektrode wirken kann. Die Beschichtung 14 ist dabei so aufgebracht, dass diese das Gewebe teilweise durchdringt, d.h. die effektive Dicke der Beschichtung mit einer Schichtdicke des Gewebes überlappt. Bei der gezeigten Bindung 1:1 (d.h. jeder zweite Faden in einer Richtung ist metallisch) ist so ein typischer Oberflächenwiderstand von 5Ω/sq realisierbar, alternativ lässt sich dieser Oberflächenwiderstand weiter verringern, indem die Bindung 1:2 oder 1:3 beträgt, d.h. das Verhältnis zwischen metallischem Faden 12 und nicht-metallischer (nicht-leitender) Faser 10 wird entsprechend angepasst.

Prozesstechnisch ist es vorgesehen, die Beschichtung (also z.B. Acrylharz) in flüssigem Zustand in das Gewebe zu bringen, so dass etwa die Tränkung bzw. Teil-Durchdringung gemäß Fig. 1 entsteht Diese kann beispielsweise dadurch passieren, dass auf eine dünne Lage flüssigen Harzes das Gewebe aufgebracht wird und nachfolgend dann eine Vernetzung des Harzes erfolgt. Alternativ möglich und auch von der Erfindung umfasst wäre eine Vorgehensweise, bei welcher die Beschichtung in Form einer Folie od.dgl. festem Zustand vorliegt und dann durch einen Druck-, Thermo- oder Pressvorgang (z.B. durch Laminieren) so in Kontakt mit dem Gewebe gebracht wird, dass die in Fig. 1 gezeigte Anordnung entsteht.

Auf eine derartige Anordnung kann eine optoelektronische Vorrichtung aufgebracht werden, wie beispielsweise im Zusammenhang mit Fig. 3 gezeigt (hier liegt das Substrat der Fig. 1 oben, wobei, umgekehrt zur Darstellung der Fig. 1, die mit der Beschichtung 10 versehene, geschlossene Außenfläche aufwärts zeigt). Pfeile 16 verdeutlichen den Lichteinfall auf die transparente Schicht 4; durch deren Polymermaterial sowie die transparenten Fibern 10 (bzw. zwischenliegende Maschen) dringt das Licht in eine unterliegende, in Kontakt mit den leitenden Fibern 12 aufgebrachte, aktive Schicht 18 ein. Diese aktive Schicht ist beispielsweise realisiert durch PEDOT + P3HT : PCBM/C60 (für organische Solarzellen) oder durch TiO2/Farbstoff/Elektrolyt(für DSC) und wird auf der gegenüberliegenden Seite von einer Gegenelektrode 20 abgeschlossen. Prinzipiell kann auch diese Gegenelektrode durch das erfindungsgemäße Substrat realisiert sein.

Mit einer beispielhaft durch geeignete Wahl der Maschenweite eingerichteten offenen Fläche von ca. 80% und einer damit erreichbaren Transmissivität für das Licht 16 von ca. 90% lässt sich so eine organische- oder DSC-Solarzelle realisieren, welche nicht nur günstige elektrische Eigenschaften aufweist, sondern mit minimierten Materialkosten und stark vereinfachten Prozessen hohe Kostenersparnisse gegenüber bekannten Solarzellen und drastische Effizienzpotenziale ermöglicht.

Fig. 2 verdeutlicht eine gegenüber Fig. 1 variierte Ausführungsform des Substrats gemäß einem zweiten Ausführungsbeispiel der vorliegenden Erfindung: hier ist ein aus Monofilamenten realisiertes Gewebe (PA, Fiberdicke 30µm bis 35µm) erst als Gewebe hergestellt und nach dem Verweben metallisch beschichtet worden, z.B. durch Plasma-Sputtern von Ag auf das Gewebe. Entsprechend zeigt die Schnittansicht der Fig. 2 eine Gewebe-Fiber-Anordnung 30, welche eine dünne Ag-Schicht (0,5µm) trägt, ggf. zusätzlich mittels einer dünnen Ti-Beschichtung stabilisiert.

Diese Anordnung wird dann, analog zum Vorgehen im Ausführungsbeispiel der Fig. 1, mit einem nicht-leitenden, transparenten Polymer versehen, so dass wiederum eine (in der Figur untere) Seite vollständig geschlossen und damit nicht-leitend ist, während, durch geeignete Wahl der Beschichtungsdicke, ein oberer Bereich der durch Beschichtung leitenden Fasern herausragt. Auch hier lässt sich der auf einen Wert < 10Ω/sq zu realisierende Oberflächenwiderstand durch andere Einrichtungen der Beschichtung od.dgl. anpassen und bietet analog dem weiteren Vorgehen gemäß Fig. 3 die Möglichkeit, eine Solarzelle, eine organische LED od.dgl. optoelektronische Vorrichtung darauf aufzubauen.

Die vorliegende Erfindung ist nicht auf die gezeigten Ausführungsbeispiele oder die vorbeschriebenen Rezepturen oder auszuwählenden Materialgruppen beschränkt; vielmehr liegt es im Rahmen geeigneter Dimensionierungen, abhängig von einem gewünschten Anwendungszweck, eine geeignete Materialstärke, Flexibilität und Belastbarkeit des Substratmaterials mit den gewünschten elektrischen Leitfähigkeitseigenschaften zu kombinieren, wobei in der vorbeschriebenen Weise und im Rahmen der Erfindung sowohl die Materialien, Dicken, Maschenweiten der verwendeten Fibern entsprechend ausgewählt oder variiert werden können, ebenso wie zur Realisierung der Elektrodenwirkung die Möglichkeit, entweder leitende (metallische oder metallisierte) Fibern in geeignetem Verhältnis einzuweben und/oder ein Gewebe in der beschriebenen Weise geeignet zu metallisieren.

Prinzipiell ist es auch im Rahmen der Erfindung möglich und vorgesehen, die erfindungsgemäße transparente, elektrisch nicht-leitende Beschichtung so vorzusehen, dass diese nicht etwa einseitig eine elektrisch nicht-leitende Oberfläche ausgestaltet, sondern im Substrat in dessen Kernbereich so vorgesehen ist, dass beidseits des Kerns jeweils Fasern bzw. Faserabschnitte aus dem Polymer herausragen und so eine leitende Schicht auf beiden Seiten des Substrats ausbilden können, siehe etwa die Darstellung in Fig. 4. Eine derartige Konfiguration bieten sich damit an, etwa dann beidseits des Substrats duale Solarzellen (Tandem) aufzubauen.

Im Ergebnis bietet das durch die vorliegende Erfindung angebotene Substrat die Möglichkeit zu drastischen Effizienzsteigerungen in Materialverwendung und Herstellung, so dass zu erwarten ist, dass der Photovoltaik- oder OLED-Technologie (aber auch weiteren optoelektronischen Anwendungen) zahlreiche neue Anwendungsfelder erschlossen werden können.

## Patentansprüche

1. Substrat für eine optoelektronische Vorrichtung, mit
einem Gewebe aus Monofilamente und/oder ein Polymer aufweisenden Fasern, welches zum Realisieren und/oder Tragen einer Elektrodenschicht ausgebildet ist, wobei
die Fasern einen Faserdurchmesser zwischen 20µm und 100µm, insbesondere zwischen 30µm und 80µm aufweisen,
und das Gewebe mit einer ein transparentes, elektrisch nicht-leitendes Polymermaterial aufweisenden Beschichtung so versehen ist, dass die Fasern zumindest teilweise von dem Polymermaterial umgeben sind,
**dadurch gekennzeichnet dass**,
das Gewebe Maschenöffnungen aufweist, die eine offene Fläche von 70 bis 85% realisieren,
und die Beschichtung so aufgebracht ist, dass das Substrat auf einer ersten, unbeschichteten Oberflächenseite elektrisch leitend und auf einer zweiten, beschichteten Oberflächenseite elektrisch nicht-leitend ist.

2. Substrat nach Anspruch 1, **dadurch gekennzeichnet, dass** die Beschichtung so ausgebildet ist, dass auf einer oder auf beiden Seiten des Substrats Fasern oder Faserabschnitte aus der Beschichtung herausragen.

3. Substrat nach einem der Ansprüche 1 bis 2, **dadurch gekennzeichnet, dass** das Polymermaterial so ausgebildet und/oder ausgewählt ist, dass die Beschichtung UV-beständig ist und/oder eine UV-Beständigkeit des Substrats befördert.

4. Substrat nach einem der Ansprüche 1 bis 3, **dadurch gekennzeichnet, dass** das Polymermaterial strahlenhärtend, insbesondere UV-vernetzbar, oder thermisch härtend ausgebildet ist.

5. Substrat nach einem der Ansprüche 1 bis 4, **dadurch gekennzeichnet, dass** das Polymermaterial so ausgewählt und/oder aufgetragen ist, dass die Beschichtung als zumindest einseitige Feuchtigkeits- und/oder Oxidationssperre für das Substrat wirkt.

6. Substrat nach einem der Ansprüche 1 bis 5, **dadurch gekennzeichnet, dass** das Polymermaterial aus der Gruppe ausgewählt ist, welches ein Acrylharz, Silikon, ein Fluoropolymer, PU, PEN, PI, PET, PA, EVA sowie Mischungen von diesen, insbesondere mit SiOx, ORMOCER oder anderen anorganischen Materialien, aufweist.

7. Substrat nach einem der Ansprüche 1 bis 6, **dadurch gekennzeichnet, dass** die Beschichtung eine Beschichtungsdicke aufweist, welche kleiner als eine Gewebedicke des Gewebes ist, insbesondere in einem Bereich zwischen 70% und 85% der Gewebedicke liegt.

8. Substrat nach einem der Ansprüche 1 bis 7, **dadurch gekennzeichnet, dass** die Fasern aus einem Material realisiert sind, welches aus der Gruppe bestehend aus PA, PP, PET, PEEK, PI, PPS, PBT, PEN, ausgewählt sind und/oder als semitransparente oder transparente Monofilamente realisiert sind.

9. Substrat nach einem der Ansprüche 1 bis 8, **dadurch gekennzeichnet, dass** eine Maschenweite der Maschenöffnungen im Bereich zwischen 200µm und 300µm liegt und/oder eine Fläche einer Maschenöffnung im Bereich zwischen 80.000µm² und 800.000µm² liegt.

10. Substrat nach einem der Ansprüche 1 bis 9, **dadurch gekennzeichnet, dass** die Fasern im Gewebe in bevorzugt regelmäßigen Abständen einen Anteil an metallisierten Fasern und/oder Metallfasern aufweisen.

11. Substrat nach Anspruch 10, **dadurch gekennzeichnet, dass** die Metallfasern Ti, Mo, W, Cr, Cu, Ag, Al, Au aufweisen.

12. Substrat nach Anspruch 10 oder 11, **dadurch gekennzeichnet, dass** die Metallfasern in das elektrisch nicht-leitende, Fasern aufweisende Gewebe in Schussrichtung oder Ketterichtung eingewoben sind, wobei das Gewebe keine zusätzliche Metallisierung aufweist.

13. Substrat nach einem der Ansprüche 1 bis 11, **dadurch gekennzeichnet, dass** das Gewebe eine Metallisierung aufweist, welche als Beschichtung auf das Gewebe aufgebracht ist.

14. Substrat nach einem der Ansprüche 1 bis 13, **dadurch gekennzeichnet, dass** Fasern, die aus Metall bestehen oder als Fasern eine Metallisierung tragen, so im Gewebe vorgesehen sind, dass das Gewebe einen Flächenwiderstand < 50Ω/sq, bevorzugt <20Ω/sq, weiter bevorzugt < 10Ω/sq, aufweist.

15. Verwendung des Substrats nach einem der Ansprüche 1 bis 14 für eine als Solarzelle ausgebildete optoelektronische Vorrichtung, insbesondere eine organische Solarzelle, Dünnschichtzelle, DSC-Solarzelle oder Tandemzelle.

16. Verwendung des Substrats nach einem der Ansprüche 1 bis 15 für eine optoelektronische Vorrichtung, welche als OLED, Display-Element, architektonisches Flächenelement oder elektronisches Passiv-Bauelement realisiert ist.

## Claims

1. A substrate for an optoelectronic device, with a fabric of monofilaments, and/or a polymer having fibres, which is designed for purposes of realising and/or supporting an electrode layer, wherein
the fibres have a fibre diameter between 20µm and 100µm, in particular between 30µm and 80µm, and the fabric is provided with a coating having a transparent, electrically non-conducting polymer material, such that the fibres are at least partially surrounded by the polymer material,
**characterised in that**,
the fabric has mesh sizes that realise an open surface area of 70 to 85%,
and the coating is applied such that the substrate on a first, uncoated surface side is electrically conducting, and on a second, coated surface side is electrically non-conducting.

2. The substrate in accordance with claim 1, **characterised in that** the coating is designed such that on one or on both sides of the substrate fibres or fibre sections protrude from the coating.

3. The substrate in accordance with one of the claims 1 to 2, **characterised in that**, the polymer material is designed and/or selected such that the coating is UV-resistant, and/or promotes a UV-resistance of the substrate.

4. The substrate in accordance with one of the claims 1 to 3, **characterised in that**, the polymer material is designed to be radiation-curing, in particular UV-crosslinkable, or thermally-curing.

5. The substrate in accordance with one of the claims 1 to 4, **characterised in that**, the polymer material is selected and/or applied such that the coating acts as a moisture and/or oxidation barrier for the substrate on at least one side.

6. The substrate in accordance with one of the claims 1 to 5, **characterised in that**, the polymer material is selected from the group which has an acrylic resin, silicon, a fluoropolymer, PU, PEN, PI, PET, PA, EVA, and mixtures of the latter, in particular with SiOx, ORMOCER or other inorganic materials.

7. The substrate in accordance with one of the claims 1 to 6, **characterised in that**, the coating has a coating thickness that is less than a fabric thickness of the fabric, and in particular lies in a range between 70% and 85% of the fabric thickness.

8. The substrate in accordance with one of the claims 1 to 7, **characterised in that**, the fibres are realised from a material which is selected from the group consisting of PA; PP, PET, PEEK, PI, PPS, PBT, PEN, and/or are realised as semi-transparent or transparent monofilaments.

9. The substrate in accordance with one of the claims 1 to 8, **characterised in that**, a mesh width of the mesh openings lies in the range between 200 µm and 300 µm, and/or a surface area of a mesh opening lies in the range between 80,000 µm² and 800,000 µm²

10. The substrate in accordance with one of the claims 1 to 9, **characterised in that**, the fibres in the fabric have, preferably at regular distances, a proportion of metallised fibres and/or metal fibres.

11. The substrate in accordance with claim 10, **characterised in that**, the metal fibres have Ti, Mo, W, Cr, Cu, Ag, Al, Au.

12. The substrate in accordance with claim 10 or 11, **characterised in that**, the metal fibres are woven into the fabric having electrically non-conducting fibres in the weft direction or the warp direction, wherein the fabric has no additional metallisation.

13. The substrate in accordance with one of the claims 1 to 11, **characterised in that**, the fabric has a metallisation that is applied as a coating onto the fabric.

14. The substrate in accordance with one of the claims 1 to 13, **characterised in that**, fibres, which consist of metal, or as fibres support a metallisation, are provided in the fabric such that the fabric has a surface resistance < 50 Ω/sq, preferably < 20 Ω/sq, further preferably < 10 Ω/sq.

15. A use of the substrate in accordance with one of the claims 1 to 14, for an optoelectronic device designed as a solar cell, in particular an organic solar cell, a thin layer cell, a DSC solar cell, or a tandem cell.

16. A use of the substrate in accordance with one of the claims 1 to 15, for an optoelectronic device, which is implemented as an OLED, a display element, an architectural surface element, or a passive electronic component.

## Revendications

1. Substrat pour un dispositif optoélectronique, avec un tissu en fibres présentant des mono-filaments et/ou un polymère, qui est conçu pour la réalisation et/ou le support d'une couche d'électrode,
dans lequel les fibres présentent un diamètre de fibre compris entre 20 µm et 100 µm, en particulier entre 30 µm et 80µm, et
le tissu est muni d'un revêtement présentant un matériau polymère transparent électriquement non conducteur, de telle manière que les fibres soient au moins partiellement enrobées par le matériau polymère,
**caractérisé en ce que** le tissu présente des ouvertures de mailles qui produisent une surface ouverte de 70 à 85 %,
et le revêtement est déposé d'une manière telle que le substrat soit électriquement conducteur sur un premier côté de surface non revêtu et électriquement non conducteur sur un deuxième côté de surface revêtu.

2. Substrat selon la revendication 1, **caractérisé en ce que** le revêtement est configuré de telle manière que des fibres ou des segments de fibres sortent hors du revêtement sur un ou sur les deux côtés du substrat.

3. Substrat selon une des revendications 1 à 2, **caractérisé en ce que** le matériau polymère est configuré et/ou sélectionné de telle manière que le revêtement soit résistant aux UV et/ou favorise une résistance du substrat aux UV.

4. Substrat selon l'une quelconque des revendications 1 à 3, **caractérisé en ce que** le matériau polymère peut être durci par rayonnement, en particulier réticulé aux UV, ou durci thermiquement.

5. Substrat selon l'une quelconque des revendications 1 à 4, **caractérisé en ce que** le matériau polymère est sélectionné et/ou déposé de telle manière que le revêtement agisse en tant que barrage unilatéral contre l'humidité et/ou l'oxydation pour le substrat.

6. Substrat selon l'une quelconque des revendications 1 à 5, **caractérisé en ce que** le matériau polymère est sélectionné dans le groupe qui présente une résine acrylique, le silicone, un fluoropolymère, PU, PEN, PI, PET, PA, EVA ainsi que des mélanges de ceux-ci, en particulier avec SiOx, ORMOCER ou d'autres matériaux inorganiques.

7. Substrat selon l'une quelconque des revendications 1 à 6, **caractérisé en ce que** le revêtement présente une épaisseur de revêtement, qui est inférieure à une épaisseur de tissu du tissu, et se situe en particulier dans une plage comprise entre 70 % et 85 % de l'épaisseur de tissu.

8. Substrat selon l'une quelconque des revendications 1 à 7, **caractérisé en ce que** les fibres sont réalisées en un matériau, qui est sélectionné dans le groupe composé de PA, PP, PET, PEEK, PI, PPS, PBT, PEN et/ou sont réalisées sous la forme de mono-filaments semi-transparents ou transparents.

9. Substrat selon l'une quelconque des revendications 1 à 8, **caractérisé en ce qu'**une largeur de mailles des ouvertures de mailles se situe dans la plage comprise entre 200 µm et 300 µm et/ou une surface d'une ouverture de maille se situe dans la plage comprise entre 80.000 µm² et 800.000 µm².

10. Substrat selon l'une quelconque des revendications 1 à 9, **caractérisé en ce que** les fibres présentent dans le tissu, à des intervalles de préférence réguliers, une proportion de fibres métallisées et/ou de fibres de métal.

11. Substrat selon la revendication 10, **caractérisé en ce que** les fibres de métal présentent du Ti, Mo, W, Cr, Cu, Ag, Al, Au.

12. Substrat selon la revendication 10 ou 11, **caractérisé en ce que** les fibres de métal sont tissées dans le tissu électriquement non conducteur présentant des fibres, dans la direction de la trame ou dans la direction de la chaîne, le tissu ne présentant pas de métallisation supplémentaire.

13. Substrat selon l'une quelconque des revendications 1 à 11, **caractérisé en ce que** le tissu présente une métallisation, qui est déposée sous forme de revêtement sur le tissu.

14. Substrat selon l'une quelconque des revendications 1 à 13, **caractérisé en ce qu'**il est prévu dans le tissu des fibres, qui se composent de métal ou qui comme fibres portent une métallisation, de telle manière que le tissu présente une résistance de surface < 50 Ω/m², de préférence < 20 Ω/m², de préférence encore < 10 Ω/m².

15. Utilisation du substrat selon l'une quelconque des revendications 1 à 14 pour un dispositif optoélectronique réalisé sous forme de cellule solaire, en particulier une cellule solaire organique, une cellule à couche mince, une cellule solaire DSC ou une cellule tandem.

16. Utilisation du substrat selon l'une quelconque des revendications 1 à 15 pour un dispositif optoélectronique, qui est réalisé sous forme de OLED, élément d'affichage, élément de surface architectonique ou élément de construction passif électronique.
